Europäisches Patentamt

European Patent Office

Office européen des brevets

(19)

(11) **EP 0 428 358 B1**

(12) **EUROPEAN PATENT SPECIFICATION**

(45) Date of publication and mention
of the grant of the patent:
**15.05.1996 Bulletin 1996/20**

(51) Int Cl.⁶: **C23C 14/32**, C23C 14/56,
C23C 14/58, C23C 14/35

(21) Application number: **90312323.0**

(22) Date of filing: **12.11.1990**

(54) **Geometries and configurations for magnetron sputtering apparatus**

Geometrie und Gestaltungen eines Geräts zum Magnetronzerstäuben

Géométrie et configurations d'une appareillage de pulvérisation pour magnétron

(84) Designated Contracting States:
**AT BE CH DE DK ES FR GB GR IT LI LU NL SE**

(30) Priority: **13.11.1989 US 435965**

(43) Date of publication of application:
**22.05.1991 Bulletin 1991/21**

(60) Divisional application: **95117528.0**

(73) Proprietor: **OPTICAL COATING LABORATORY,
INC.
Santa Rosa, California 95407-7397 (US)**

(72) Inventors:
• **Seeser, James W.**
**Santa Rosa, California 95404 (US)**
• **Allen, Thomas H.**
**Santa Rosa, California 95405 (US)**
• **Dickey, Erik R.**
**Northfield, Minnesota 55057 (US)**
• **Hichwa, Bryant P.**
**Santa Rosa, California 95404 (US)**
• **Illsley, Rolf F.**
**Santa Rosa, California 95409 (US)**
• **Klinger, Robert F.**
**Rohnert Park, California 94928 (US)**
• **Lefebvre, Paul M.**
**Santa Rosa, California 95401 (US)**
• **Scobey, Michael A.**
**Marlborough, Massachusetts 01752 (US)**
• **Seddon, Richard I.**
**Santa Rosa, California 95404 (US)**
• **Soberanis, David L.**
**Santa Rosa, California 95404 (US)**
• **Temple, Michael D.**
**Santa Rosa, California 95401 (US)**
• **Van Horn, Craig C.**
**Sebastopol, California 95472 (US)**
• **Wentworth, Patrick R.**
**Santa Rosa, California 94501 (US)**

(74) Representative: **Bayliss, Geoffrey Cyril et al
BOULT, WADE & TENNANT
27 Furnival Street
London EC4A 1PQ (GB)**

(56) References cited:
**EP-A- 0 269 446          EP-A- 0 328 257
EP-A- 0 409 451          US-A- 4 420 385**

• **XEROX DISCLOSURE JOURNAL, vol. 9, no. 3,
May/June 1984, pages 173-175, XeroxCorp.,
Stamford, Connecticut, US; G.P. CEASAR et al.:
"Multiple drumfabrication for ion beam
deposited a-Si:H photo-receptors"**

# Description

The present invention relates to sputtering processes and related apparatus. More particularly, the present invention relates to apparatus and processes for high rate, uniform deposition and formation of thin films of material, such as refractory metals and/or oxides, nitrides, hydrides, carbides, fluorides and other compounds and alloys of such metals, and also to the deposition and formation of composite films. Because the process and apparatus of the present invention are designed to satisfy the stringent requirements of optical coatings, they are applicable as well to a number of other coating applications having less rigorous requirements.

DC magnetron reactive sputtering has been developed in recent years as a technique for producing layers of dielectric materials, particularly metal oxides, and oxide semiconductors particularly indium tin oxide. The technique has advantages compared with the RF magnetron techniques for sputtering dielectric materials directly, in that deposition speed gains can be realized, and production equipment is less costly, safer, and easier to control.

It is the conventional wisdom in the coating technology that any process which seeks to take full advantage of the D.C. magnetron sputtering technique and to avoid its potential disadvantages must preferably use partial pressure separation of the substrate and sputtering cathodes. Several approaches have been proposed for implementing partial pressure separation. See, for example, Hartsough U.S. Patent No. 4,420,385; Schiller et al "Advances in High Rate Sputtering with Magnetron-Plasmatron Processing and Instrumentation", TSF 64 (1979) 455-67; Scherer et al "Reactive High Rate DC Sputtering of Oxides", (1984); and Schiller et al "Reactive DC Sputtering with the Magnetron-Plasmatron for Titanium Pentoxide and Titanium Dioxide Films", TSF 63 (1979) 369-373.

The Scherer technique employs cathodes baffled in such a away as to create an oxidation zone located directly over the sputtering zone. In all other regards, this technique is not directly relevant to our invention as it is designed to deposit material in a single pass and also in that the oxidation of the metal vapor takes place as it is deposited.

The Schiller and Hartsough techniques alternate a substrate between a sputtering cathode and a reactive gas sorption zone, which is the more effective technique for achieving pressure separation. The most complete description of this partial pressure technique is contained in the Hartsough patent, which discloses the formation of non-optical quality wear-resistant aluminum oxide coatings on a disk by rotating the disk past a single sputtering deposition zone and a single oxidizing zone. The entire volume outside the sputtering zone is used as the reaction or oxidation zone, thus the boundaries of the two zones are in contact. Extremely tight baffling between the sputtering cathode and the substrate carrier is required to avoid migration of the reactive gas into the deposition zone. This limits the pressure available for oxidation. Also, the deposition rate available using this approach is inherently limited by the oxidation rate. That is, as the power to the cathode is increased to increase the metal sputtering rate, the table rotational speed must be increased so that the optimum thickness of material is deposited within the deposition zone. However, as the translational speed of the table is increased, the dwell time within the oxidation zone decreases proportionately, with the result that at the limit there is insufficient dwell time within the reaction zone to completely oxidize the metal layer.

The above-described partial pressure technique has at least several additional serious disadvantages.

For example, if one or more additional sputtering cathodes were required for the purpose of providing the capability to deposit other materials in the same apparatus in the same vacuum cycle, the reaction time per translation cycle would be proportionately reduced by the number of additional cathodes. Also, the deposition rate for each material would be proportionately reduced. The technique as described permits only one reaction volume which is always effective and thus precludes the simultaneous deposition of two different metal oxides or other compounds or a pure metal and a compound.

Finally, but not exhaustively, the annular rotating arrangement with its radial speed differential and requirement for a specially shaped magnetron sputtering target places severe restrictions on the achievable film thickness uniformity such that for optical thin film practice the useable portion of the apparatus described would be a narrow annular region.

It is obvious then that the described prior art approach would have difficulty in achieving production of even modest commercial volumes of multi-layer optical filter devices. Also, because of the disadvantages described, if applied to the practical production of multi-layer optical devices, this approach would have no greater throughput than a conventionally-operated RF Magnetron apparatus of the same size and configuration.

EP-A-0409451 (cited under article 54(3) discloses a rotary cylindrical sputtering system which incorporates a separate linear magnetron sputter deposition and reaction zones which are also separately controlled for sputter depositing materials such as refractory metals and forming oxides and other compounds and alloys of such materials. The process involved rotating or translating workpieces past differentially pumped, atmospherically separated, sequentially or simultaneously operated deposition and reaction zones.

This invention provides a coating apparatus comprising, a vacuum chamber, carrier means mounted within said chamber and adapted for mounting substrates thereon; coating means comprising at least a first device in the form of a deposition device positioned adjacent the carrier means and adapted for depositing a selected material dnto the substrates and at least a second device in the form of an ion source device positioned adjacent the carrier means and adapted for providing a locally intensified plasma between the ion source and the carrier means for effecting a selected chemical reaction with the selected material, the deposition device and the ion source device being spatially separated such that each acts on a different portion of said carrier means, the carrier means and the coating means being adapted for relative movement along a selected path,and the coating means being positioned adjacent said path of movement, the combination of carrier configuration, deposition device configuration and said relative movement being selected to provide controlled thickness profiles for deposited material; wherein said path is circular and the carrier means is flat or the plane of the carrier means is oriented at a small angle relative to the normal to the rotational axis and is adapted for movement along said path generally parallel the coating means.

The carrier means further comprises means mounting the substrates thereto for movement transverse to the rotational path of movement.

In a specific arrangement according to the invention the carrier means is adapted for mounting substrates thereon in an array oriented generally transverse to the axis of rotation of the carrier means, for rotating the substrates about said axis of rotation; and wherein the coating means comprises at least one film deposition device positioned at a work station adjacent and facing the substrate array and adapted for depositing a selected material onto the substrates and at least one ion source device positioned adjacent and facing the substrate array and adapted for providing a plasma for effecting chemical reaction with the deposited material; and wherein the devices are adapted for movement relative to the carrier means, transverse to the axis of rotation.

In the latter arrangement the devices may be mounted for selected radial movement relative to the carrier means.

In any of the above arrangements the deposition device may be selected from a magnetron-enhanced device, one or an array of point source sputter guns, a stationary evaporation source, a centrifugal-force rotating evaporation source and a reactive ion plating source and the at least one ion source device is selected from a self-starting magnetron device, a point source device and a device adapted for generating a plasma of low energy ions.

Further, the ion source device may comprise electrode means adapted for receiving a selected voltage for generating a controlled electric field gradient between the ion source device and the carrier means; means for applying a magnetic field about the electrode means transverse to the electric field; manifold means for supplying gas locally to the electrode means; and means for supplying electrons locally to the electrode means and into the region of transverse electric and magnetic fields, for forming a plasma of said gas, whereby reactive gas ions are accelerated by said electrode potential along the electric field gradient toward the traversing means and substrates.

The invention also provides a process for forming optical coatings on substrates comprising: mounting the substrate on carrier means within a vacuum chamber; providing coating means comprising at least a first device in the form of a deposition device positioned adjacent the carrier means and adapted for depositing a selected material onto the substrates and at least a second device in the form of an ion source device positioned adjacent the carrier means and adapted for providing a plasma for effecting a selected chemical reaction with the selected material; and operating the coating means for forming a selected optical coating on the substrates while moving at least one of the carrier means and the coating means relative to the other along a path selected to provide substantially equal deposition rates for similarly configured spaced substrates; wherein the carrier means is flat or the plane of the carrier means is oriented at a small angle relative to the normal to the rotational axis and adapted for mounting substrates thereon in a plane oriented generally perpendicular to the axis of rotation of the carrier means; providing at least one deposition device positioned at a work station adjacent and facing the substrate plane; providing at least one ion source device positioned adjacent and facing the substrate plane for providing a locally intense plasma adjacent the workpiece carrier; introducing working and reactive gases and rotating the carrier means to move the substrates past the first and second devices through said reaction zone associated with the second reaction device.

The process may further comprise selectively operating the deposition and the reaction devices to form a composite coating comprising at least a plurality of layers, the composition of each said layer being selected from at least one of a first metal, a second metal, an oxide of the first metal, an oxide of the second metal, mixtures of the first and second metals and oxides of mixtures of the first and second metals.

Further, the process may provide at least a plurality of the deposition devices; sequentially operating selected ones of the deposition devices to sputter deposit layers of selected materials on the substrates and selectively operating the at least one reaction device in conjunction with supplying selected reactant gas thereto for effecting the selected reaction with at least selected ones of the layers prior to sputter deposition of the next successive layer.

By way of example the selected reaction may involve selectively converting the deposited material to at least one of oxide, nitride, hydride, sulfide, fluoride, and carbide compounds and mixtures.

Specifically, the selected reaction selectively may convert the deposited material to an oxide thereof.

A. Characteristics of Deposition And Reaction Zones

In one embodiment of our invention which differs fundamentally from the prior art, both deposition and reaction are effected in long narrow axial zones that are adjacent and moved relative to the periphery of a substrate carrier. The reaction is effected by means of a highly intense plasma in a highly efficient manner at high gas pressures in a long narrow zone, isolated physically from the metal deposition zone by a region of relatively low pressure. Through the use of a reactive ion source, such as the linear magnetron or suitably configured ion gun, configured to produce an elongated uniform high intensity ion flux adjacent the periphery of the carrier for generating an intense reactive plasma from oxygen or other gas, the high pressure reactive volume is substantially comprised of highly energetic gas species, which greatly shortens the time required for the reaction. A further resulting advantage of this technique is that the technique is not limited to reactive gases such as oxygen, for compounds can be formed using other gases such as nitrogen; hydrogen; hydrogenated carbon-containing gases such as butane, methane, acetylene, etc.; fluorine; hydrogenated fluorine-containing gases such as freon, etc.; and gaseous oxides of carbon, to form nitrides, hydrides, fluorides, carbides, etc., and alloys and mixtures. The invention overcomes the disadvantages of the prior art and affords further advantages in that considerable deposition speed increases can be realized through the use of scaling and multiple stations. The available gas pressures and deposition rates are well above the practically attainable deposition rates using prior art equipment. Curved substrates can also be coated due to the elimination of the requirement for tight baffling.

B. Present System and Method of Operation

According to one aspect of our invention, substrates on a substantially flat form carrier means rotate past a set of processing station, and/or vice versa, which form thin film coatings on the substrates, including refractory metal coatings and optical quality dielectric coatings such as metal oxide. The preferred substrate carrier configuration used in our system is a rotating disk system. The base carrier configuration may inherently deposit at different rates on similarly configured (e,g., flat) substrate surfaces or surface regions depending upon the position of the substrate on the carrier. The configuration of the carrier means itself, the configuration of the deposition device and/or the relative movement of the substrate carrier means and the deposition device may be adapted to decrease any such tendency to deposit at different rates, and otherwise configures the system to promote uniform deposition rates.

The deposition devices may be selected from one or more of (a) stationary magnetron devices; (b) rotating magnetron devices; (c) point source sputter guns; (d) stationary evaporation sources; (e) centrifugal-force rotating evaporation sources; and (f) reactive ion plating sources. Also, the ion source chemical reaction device may be selected from one or more of (a) self-starting ion guns; (b) non-self-starting ion guns; (c) point ion sources; (d) microwave sources; (e) unbalanced magnetron sources; (f) RF sources; and (g) arc sources.

Alternative magnetron versions comprise (1) at least one magnetron-enhanced sputter deposition device or cathode (a planar magnetron-enhanced device or a rotating cylindrical target magnetron-enhanced device or a rotating magnetron-enhanced multiple target device) operating in a metal deposition mode for depositing silicon, tantalum, etc., and (2) a similar device such as a linear magnetron-enhanced device operating in a reactive plasma mode, or an inverse magnetron ion gun or other ion gun or other ion source configured to produce an elongated uniform high intensity ion flux adjacent the periphery of the carrier, for generating an intense chemically reactive plasma, using oxygen and/or gases such as those listed above. Preferably this arrangement is used to provide the above-described long narrow zones for both deposition and reaction with complete physical separation of the zone boundaries. When devices such as similar linear magnetron-enhanced cathode devices are used, one may be operated using a relatively low partial pressure of the gas (such as oxygen) to provide the metal deposition mode while the other is operated at a relatively higher reactive gas partial pressure to generate the intense reactive plasma for oxidation, etc.

The arrangement is scalable in that a multiple number of devices can be used in each processing station set to increase the deposition rates and the number of materials formed. Various processing station arrangements can be provided in a chamber for depositing and oxidizing different or otherwise reacting with metals separately, sequentially or simultaneously. As one example, four stations can be selectively arranged and operated to perform the sequence silicon deposition, oxidation, tantalum deposition and oxidation, to quickly form alternating layers of silica and tantala. For example, one or more silicon deposition stations and one or more associated oxidation stations can be operated simultaneously in tine and sequentially in space to form $SiO_2$ layers which are alternated with $Ta_2O_5$ layers formed in the same manner.

In our process, the relationship between the power of the deposition cathodes and the speed of rotation or translation of the substrate can be tailored so that in each pass, a deposited thickness of one or more atomic layers can be obtained. By adding additional cathodes of other materials, and by adjusting the power to each cathode, effectively alloys can be created of any desired ratio. For example, NiCr can be formed in any desired ratio from cathodes of Ni and Cr, over large areas, simply by adjusting the relative power to the cathodes. By adding oxidation stations, one can form complex oxides such as barium copper yttrium oxide, forms of which are known to be superconducting.

The above and other aspects of the invention are described with respect to the drawings in which:

FIGS. 1 and 2 are, respectively, a simplified schematic perspective view and a simplified schematic horizontal sectional view, both of a single-rotational cylindrical drum magnetron-enhanced vacuum sputtering system which does not embody the present invention but will be described by way of relevant background information.

FIGS. 3 and 4 are, respectively, a simplified schematic perspective view, partially cut away, and a simplified schematic horizontal cross-sectional view of one type of DC linear magnetron sputtering device used in the magnetron-enhanced vacuum sputtering system of the present invention;

FIGS. 5 and 6 are, respectively, an exploded perspective view and an end view, partly in schematic, of an inverse linear magnetron ion source used in the magnetron-enhanced vacuum sputtering system of the present invention;

FIGS. 7 to 9 depict disk systems which incorporate a dual rotary disk arrangement (FIG. 7 ), dual rotating disks and radially translatable targets (FIG. 8 ) and a slanted, centrifugal force-substrate hold disk (FIG. 9);

FIG. 10 schematically depicts another alternative deposition source arrangement, in the form of point source sputtering guns or S-guns;

FIGS. 11 to 14 schematically depict alternative arrangements of thermal evaporation deposition sources, i.e., systems which employ resistance heating (FIG 11), electron beam heating (FIG. 12), and laser heating (FIG 13), as well as a centrifugal force, side mount crucible arragement (FIG. 14);

FIG. 15 depicts a modified rotary version of the plasma plating system disclosed in US-A-4,777,908;

FIGS. 16A and 16B disclose modified arrangements of the inverse linear magnetron ion source gun of FIGS 5 and 6 which incorporate, respectively, a thermionic electron emission system and a hollow cathode emission system, for providing independent, self-starting, operation and enhanced stability;

FIG. 17 depicts another ion source system, in the form of one or more so-called point source ion guns;

FIG. 18 depicts still another ion source system, in the form of a microwave-driven source; and

FIG. 19 depicts an alternative geometry in the form of a rotating, linear magnetron, multiple target system.

## A. Rotary Systems

### 1. Sputter Systems

A general description of certain forms of sputter deposition systems will precede a description of some specific embodiments of the invention. A number of the systems described include substrate carriers in the form of rotating cylindrical carriers in-line translation systems and web-type carrier systems. None of these forms of substrate carriers is within the scope of the present invention and the systems are described solely as examples of different coating systems. Linear DC magnetron-enhanced sputtering cathodes operating in a partial pressure separation regime combined with rotary cylindrical workpiece transport to provide a sputter deposition system which is capable of high rate formation of single or multi-layer optical films of materials such as, but not limited to, $SiO_2$, $TiO_2$ and $Ta_2O_5$. This combination is achieved despite the previous incompatibility of linear magnetron sputterers and rotary workpiece transport and despite the inherent difficulty (as evidenced in the prior art) in implementing partial pressure separation.

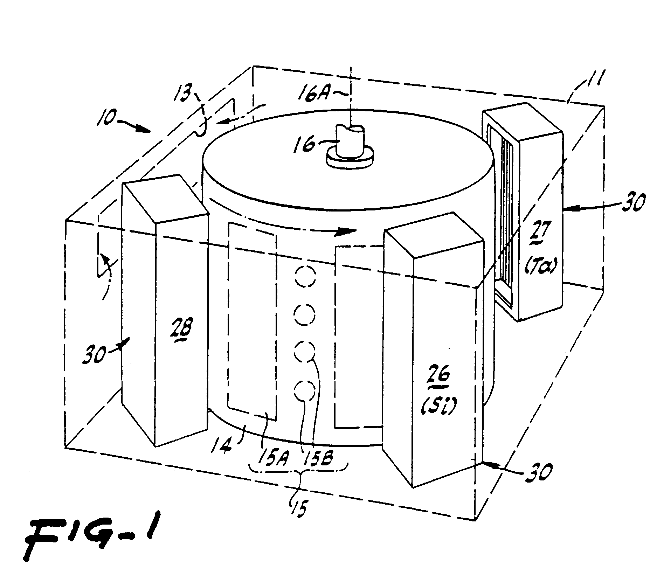

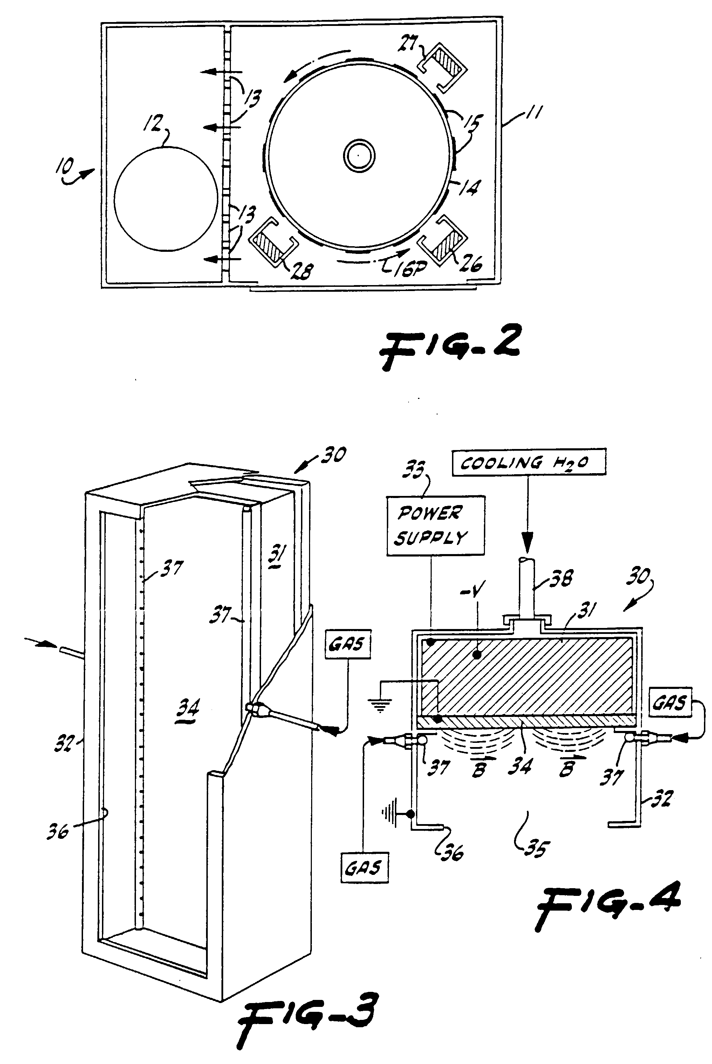

FIGS. 1 and 2, respectively, depict a simplified schematic perspective view and a horizontal sectional view of a single rotation magentron enhanced vacuum sputtering system. The illustrated sputtering system 10 comprises a housing 11 which forms a vacuum processing chamber and is connected to a suitable vacuum pumping system 12 shown in FIG. 2. The vacuum pumping system includes a cryopump or other suitable vacuum pump or combinations thereof for exhausting and pumping down the vacuum chamber via exhaust port 13. The system 10 also includes a drum 14 which is mounted for rotation about shaft 16 and has a cylindrical side which is adapted for mounting substrates 15 of various configurations and sizes. The substrates 15 can be mounted directly on the drum 14, facing outwardly toward sputtering stations which are spaced about the external periphery of the drum or facing inwardly toward sputtering stations spaced along the internal periphery of the drum. The drum arrangement does not form part of the present invention.

Referring further to FIGS 1 and 2, a plurality of linear magnetron-enhanced sputtering devices, designated generally by the reference numeral 30, are positioned about the outer periphery of the drum 14. In one exemplary embodiment, the station designated 26 is used to deposit material such as silicon whereas station 27 deposits a different material such as tantalum and station 28 is used to react a gas such as oxygen with the substrates to convert the deposited metal layer(s) to oxide. (Reference numerals 26-28 refer to the processing stations and to the devices at the stations.) Thus, by rotating the drum 14 and selectively operating the sputtering and reaction stations 26, 27 and 28, the metals and/or oxides thereof can be selectively formed on the substrate in essentially any desired combination. For example, by rotating drum 14 and sequentially activating the sputtering cathodes in the sequence 26, 27, while operating the associated reaction station(s) 28, system 10 can form a silicon layer a few atoms thick and oxidize the silicon to $SiO_2$, then deposit a layer of tantalum a few atoms thick and oxidize the tantalum to $Ta_2O_5$. This sequence can be repeated and altered as required to form a composite optical coating of layers of $SiO_2$ and $Ta_2O_5$ of precisely controlled thicknesses. It should be noted that oxidation stations 30 such as the one at station location 28 can use a planar magnetron cathode similar to those used at deposition stations 26 and 27, by substituting oxygen for the argon; or can use other ion sources capable of generating a reactive ionized plasma, such as ion guns or the inverse linear magnetron ion source described below, or other devices such as those described below, which generate the required reactive DC or RF plasma. The drum arrangement does not form part of the present invention.

## 2. DC Magnetron Sputter Deoposition Device

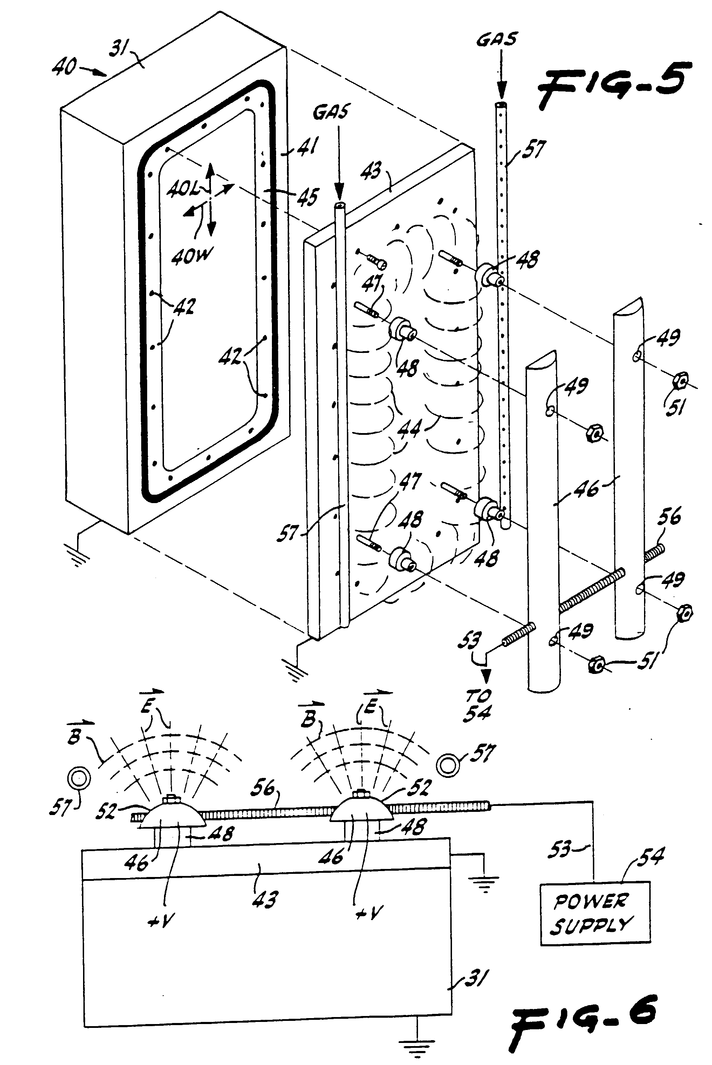

FIGS. 3 and 4 schematically illustrate one type of planar DC magnetron sputtering device 30 which is commercially available from VacTec or other suppliers and can be used at station locations 26 and 27 and, optionally, at station 28, FIGS. 1 and 2. The sputtering device 30 comprises a housing which mounts an electrode 31 and forms a front, gas baffle 32 having an opening 36 which is selectively closed by a shutter (not shown). Electrode 31 is connected to a power supply 33 for applying a voltage of, e.g, -400 v. to -600 v. to the electrode relative to the baffle 32, which is at anode potential (usually ground). Permanent magnets (not shown) are mounted within the electrode body for supplying a magnetic field $\bar{B}$ of rectangular racetrack configuration along the surface of the target 34 and perpendicular to the applied electric field. Manifold tubes 37 are situated adjacent the target 34 and are connected to a source of gas for supplying reactive gas such as oxygen or an inert working gas such as argon to the sputter chamber 35 defined by baffle 32 and target 34. The device is cooled by water which is supplied via inlet 38 and circulated to an outlet (not shown). The baffles 32 in the individual sputter devices 30 effectively divide the overall processing chamber 10, FIGS. 1 and 2, into different regions or sub-chambers at each sputterer in which different gas atmospheres and/or gas partial pressures can be established. Improvements could be readily implemented where one or more additional pumps could be placed to improve separation between regions of reactive and non-reactive gases.

Compounds, etc., such as oxide dielectric films can be formed using the linear magnetron sputter devices 30 at the sputter stations 26 and/or 27 and using a different type of device, such as the ion source 40 which is described in the next section, at reaction station(s) 28. Alternatively, one can use linear magnetron sputter devices 30 at the sputter stations 26 and/or 27 and/or at the reaction station 28. In both cases, the sputter device and the ion source device are enclosed in distinct partial pressure regimes or chamber regions between which the substrate is alternated by the continuously rotating drum. When baffled magnetron cathodes 30 are used both to sputter and to oxidize, the cathodes are operated at relatively high power density in an oxygen ambient within chamber 10 using a target designed for sputtering the selected metal such as silicon or tantalum. However, the baffle-separated magnetron cathodes which are used at stations 26 and 27 for metal deposition are operated in a low reactive gas (oxygen) partial pressure environment for operating in a metal mode and depositing metal at consequentially high rates. The low oxygen partial pressure is supplied by flowing inert working gas such as argon into the chamber area via gas inlet manifolds 37. The other type of baffled magnetron cathode 28 is operated at relatively higher reactive gas partial pressure and sputter deposits the metal at a much lower rate on the moving substrates but oxidizes the metal at a much higher rate. The lower rate target adds little to the overall deposition rate and thus does not affect control, but does produce a highly reactive plasma which allows the chamber oxygen to readily react with the growing thin film and, as a result, permits the use of a relatively low overall chamber oxygen partial pressure, which enhances cathode stability and rate. This reactive sputtering approach provides repeatable thin films deposited at high rates, fully oxidized and with good optical qualities.

## 3. Inverse Linear Magnetron-Type of Ion Source

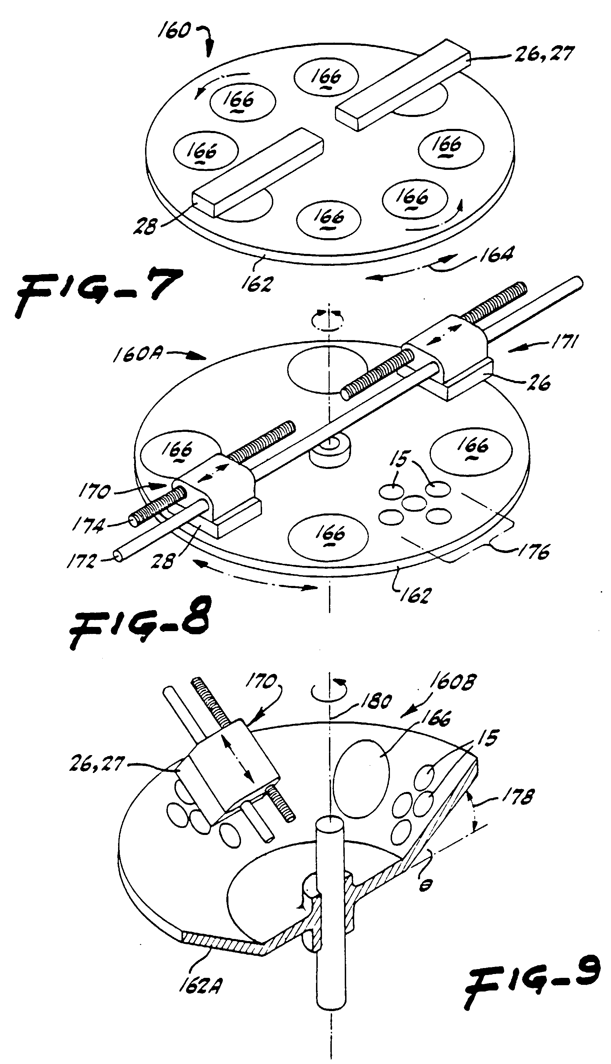

FIGS. 5 and 6 depict a presently preferred embodiment of an inverse (or reverse-biased) linear magnetron-type of ion source 40 which is used at ion source reaction station(s) 28, FIGS. 1 and 2 to provide the desired narrow elongated reaction zone. The ion source 40 uses electrons associated with the sputtering plasma to generate ions from a reactive gas in a separate local plasma. These ions bombard the sputter-deposited material on the substrates and thus form compounds with the sputtered material. The ion source 40 can use the electrode body or assembly 31 and the housing 32 shown in FIGS. 3 and 4 (for clarity, housing 32 is deleted in FIGS. 5 and 6). As adapted for use as a linear magnetron ion source, direct-cooled electrode assembly 31 includes an O-ring seal 41 and tapped holes 42 in the face to insulatingly mount a non-magnetic stainless steel cover plate 43 in place of target 34 to seal water circulation channel 45 in the body 31. As mentioned previously, body 31 also incorporates permanent magnets (not shown) which provide a magnetic field B of elongated rectangular "race track" configuration 44 along plate 43 when the plate is assembled to the body 31. The ion source 40 is mounted adjacent the periphery of the rotatable substrate carrier 14 with its long direction or axis 40L parallel to axis 16A of the carrier 14, FIG. 1, and the width or short axis 40W parallel to the circumference.

A pair of stainless steel bar anodes 46-46 are mounted along the elongated opposite sides of the magnetron race track 44 on posts 47 which themselves are mounted to the non-magnetic plate. The anodes 46 are insulated from the posts 47 and plate 43 by stepped insulator stand-offs 48 having relatively small sections which extend into holes 49 in the bar anodes 46 and larger bottom sections which serve to precisely space the anodes from the stainless steel plate 43, as shown in FIG. 7. For mounting, the posts 47 are inserted through the stand-offs 48 and through the holes 49 in the bar anodes 46, and are secured by nuts 51.

Each anode 46 is a straight bar which is slightly shorter than the long side of the magnetron race track 44. Each anode's curved, generally semi-cylindrical outer-facing surface 52 conforms closely to the shape of the magnetic field lines, $\bar{B}$, FIG. 7. The anodes 46 are connected through wire leads 53 to a conventional power supply 54 capable of providing several amps current at, for example, +50 volts to +140 volts bias. Preferably, insulating beads 56 (or other suitable insulation) are mounted along the section of the leads 53 within the housing to isolate the leads from the plasma and prevent discharge at the wire. Typical operation is at 2 to 4 amps and 100 to 120 volts for a nominally twenty inch long magnetron electrode.

As mentioned, the mounting location or station of the inverse linear magnetron ion source 40 is outside the sputtering region(s) 26 or 27 but within the associated plasma, which extends essentially throughout the vacuum sputtering chamber. In operation, the power supply 54 is used to maintain the stainless steel bar anodes 46 at a positive DC voltage of, for example, 100 to 120 volts relative to the electrode assembly 31 and the stainless steel plate 43, which are at system ground and at an even greater positive potential with respect to electrons in the surrounding plasma. As shown most clearly in FIG. 7, the curved surfaces 52 of the anodes provide electric field lines $\bar{E}$ which are substantially perpendicular to the magnetic field lines $\bar{B}$. Electrons in the associated plasma are accelerated towards the positive anodes 46 and are trapped or confined by the resultant $\vec{E} \times \vec{B}$ field along the magnetron race track, greatly enhancing the probability of collisions with the reactant gas supplied via adjacent inlet manifolds 57, and thereby generating an intense plasma defined by the race track configuration 44. That intense plasma generates many ions from the reactant gas which are accelerated away from the anodes 46 by the potential gradient existing between the anodes and the background plasma and toward the substrates. These energetic, directed ions enhance the reaction process, e.g., by enhancing oxidation of sputtered metals using oxygen as the reactant gas.

In short, during operation, the elongated inverse linear magnetron ion source 40 provides an intense long narrow reaction zone defined by the magnetron race track 44 to have the long dimension thereof spanning substantially the height of the substrate carrier drum 14 and the narrow dimension thereof defined along the circumference of the carrier parallel to the direction of rotation. In distinct contrast to the prior art's requirement that substantially the entire volume outside the single sputtering zone be used for oxidation, in the current version, our ion source 40 has a reaction zone which is only about approximately 12.7cms to 15.24cms (five to six inches) wide and occupies a small fraction of the circumference of the 73.66 cms (29 inch) diameter drum 14 (12,7cms/ $\pi$ D= 12.7cms/227.5cms = 5.5%) or (5"/$\pi$ D = 5"/91" = 5.5%). As before, the drum arrangement does not form part of the present invention. Due to the intense magnetic field-enhanced plasma reaction, this reaction zone completely oxidizes the deposited thin film in, typically, a single pass. The small ion source size and the fast reaction rate provide unique upward scaling capability, enabling the use, e.g., of a multiple number of deposition devices such as linear magnetron-enhanced sputter cathodes and of inverse linear magnetron oxidation reaction devices to provide high rate, high volume, high throughput deposition and versatility in the selection of the composition of the deposited coatings.

The combination of the rotatable drum and baffled magnetron-enhanced linear sputtering cathodes and inverse magnetron-enhanced ion source reaction devices has provided high rate, precisely controllable optical quality metal and dielectric layers in thicknesses which are scalable, on both flat, curved and irregularly shaped substrates with a minimum of masking. Also, because a given layer is built up by a multiplicity of coating passes, the effects of cathode arcs are greatly decreased since any such arc represents only a portion of the coating. Additionally, when operating in the metal mode, magnetron arcs are typically less frequent and intense.

The process described above involves sputtering metal materials such as, but not limited to, silicon, tantalum, titanium, iron or any other sputterable material in an atmosphere that permits the target to operate in the metal mode, characterized by the highest rate of sputtering, while elsewhere in the machine establishing an ion process which preferably uses magnetron-enhanced sputtering to expose the freshly deposited film to a reactive atmosphere that converts it to, for example, an oxide. The metal preferably is deposited no more than a few atoms thick in order that the oxidation during the subsequent reaction process is complete. Typically, the sequence of sputter deposition, oxidation, sputter deposition, oxidation is repeated as required to build up the oxide layer to the desired thickness of material such as $SiO_2$. Then if a different layer such as $Ta_2O_5$ is to be formed the same repetitive process is repeated. Quite obviously, various oxide forming cycles and metal deposition cycles can be applied as required to form composites of oxides alone, oxides and metals, or metal(s) alone.

As mentioned above, a locally intense ionized reactive plasma from an ion source such as an ion gun or a planar magnetron is used to provide the oxidizing reaction. The uniformity of the magnetron sputter-deposited metal films is precise, and the cylindrical geometry allows uniform distribution of sputtering materials. Thus, it is possible to use time and power control of the process and almost any width or length of cathode, thereby overcoming the historical problems of controllability, scalability and throughput associated with conventional DC magnetron reactive processes. As demonstrated in the examples below, this ability permits precision deposition of fractional optical layers such as one-sixteenth visible wavelength optical layers which are difficult to deposit using conventional vacuum evaporation processes.

5. Summary of Rotary System Operation

Prior to considering specific examples, it is helpful to review the sequential steps used in our presently preferred method of operating the rotary magnetron sputtering apparatus. Because the examples described below were obtained using the single and double rotational apparatus depicted in FIGS. 1-2, the method of operation is keyed to this apparatus and to revised embodiments of this apparatus which use four (or more) metal sputtering and oxidation/reaction stations. For simplicity, we refer to the exemplary linear magnetron-enhanced type of sputtering devices as cathodes or sputtering cathodes.

Initially, the reflectors or tubes or other substrates are mounted on the periphery of the drum. The vacuum enclosure/chamber is then pumped down to a background pressure of, for example, $1.33322 \times 10^{-4}$ N/m$^2$ ($1 \times 10^{-6}$ torr) and rotation of the drum at the selected speed is initiated.

Next, the metal sputtering cathodes which are to be used during a selected coating sequence are started up by flowing the sputter gas, illustratively argon, through the inlet manifolds 37 and applying power to the cathodes 31 via associated power supplies 33. Prior to the initiation of the deposition/(deposition plus oxidation) coating cycle, the sputtering cathode shutters are kept closed to prevent deposition.

Once the operation of the sputter cathodes has been initiated, operation of the ion source or ion sources 40 is started. As mentioned, operation of ion source 40 utilizes the plasma associated with the operation of the sputter cathode(s) 30 and, thus, requires prior operation of the sputter cathode. Certain other ion sources, such as the sputter cathode 30 operating in an oxidizer mode, do not depend upon a separate plasma for operation but it typically is preferable not to start even these devices until operation of the sputter cathode has stabilized. Operation of the ion source(s) is initiated by applying the inlet flow of oxygen or other desired reactant gas or mixtures thereof via the inlet manifolds 57 and by applying power via power supply 54.

With the sputter cathodes and ion sources established at stable operating conditions, that is, at stable selected power, gas flow and pressure and with the drum operating at the specified rotational speed to provide selected deposition and oxidation rates, the desired deposition and oxidation sequence is effected by selectively opening the shutters. For example, and assuming that two sputter and two oxidation stations (one oxidation station may suffice) are positioned around the periphery of drum 14 in the sequence metal 1 cathode, ion source oxidizer, metal 2 cathode and ion source oxidizer, the following coatings can be attained by the associated sputter cathode shutter opening sequence (please note, oxidation is continuous and the oxidizer device shutters are maintained open, except when layers are deposited which are not oxidized; during non-oxidation periods, the oxidizers are rendered inoperative, e.g., by keeping the shutters closed, see example 2, metal 1):

1. Metal 1 deposition, oxidation, metal 2 deposition, oxidation → metal 2 oxide on metal 1 oxide;

2. Metal 1 (oxidizer shutters closed), metal 2, oxidation → metal 2 oxide on metal 1;

3. Metal 1, oxidation, metal 2 (oxidizer shutters closed) → metal 2 on metal 1 oxide;

4. Metal 2 (oxidizer shutters closed), metal 1, oxidation → metal 1 oxide on metal 2;

5. Metal 2, oxidation, metal 1 (oxidizer shutters closed) → metal 1 on metal 2 oxide;

6. Metal 1 and metal 2 simultaneously without oxidizers (i.e., the shutters for the metal 1 cathode and the metal 2 cathode are opened simultaneously and the oxidizers are off or the shutters closed) → a layer which is a mixture of metal 1 and metal 2; and

7. Metal L and metal 2 simultaneously, oxidation → an oxidized mixture of metal 1 and metal 2.

Quite obviously, an essentially unlimited number of combinations of multi-layer coatings can be formed of various materials and using a multiplicity of cathodes.

Please note, during the formation of mixtures of two or more metals and/or other materials, preferably the sputter cathode shutters are maintained open and the ratio of one material to another or to others is varied by adjusting the power, the pressure, the relative aperture size and/or the relative number of cathodes.

Also, in general, the thickness of a particular layer, either a compound or mixture or discrete material, is determined by the length of time the associated sputter cathode shutter(s) is open.

Based upon the above description and the following examples, those of usual skill in the art will be able to derive essentially an unlimited number of combinations of different compositions, compounds, alloys and mixtures of single and multi-layer metals and other materials and their oxides, nitrides, carbides, etc., including complex materials such as superconductors.

The capability to form films of composite materials and alloys extends to films of continuously varying composition, and thus continuously varying optical properties, in a direction perpendicular to the substrate plane. The composition profiling can be accomplished by continually or periodically varying the power applied to one or more of the sputtering cathodes or by continually varying the aperture or shutter opening at one or more of the sputtering cathodes. Three important device categories are:

Transparent anti-reflecting coatings. These can be produced comprising a single film with a refractive index varying from the refractive index of the substrate material at the substrate to the lowest practical value at the outer interface. Such devices would typically be used to provide anti-reflection coatings effective over very broad bandwidths, generally two or more octaves wide.

Opaque anti-reflection coatings. Typically these coatings, which are used to provide general and selective absorbing surfaces on metal surfaces, can be produced by varying the film composition from 100 percent of some metallic component to 100 percent of some transparent material at the outer interface.

Transparent films of continuous periodically varying profile. The refractive index profile could be a simple profile of a fixed frequency, or a more complex frequency-modulated profile. Typical uses of such structures would be as very narrow band reflectors having one or more discrete narrow reflection bands separated by regions of high transmission. A typical application of such devices would be for the protection of the eye or protection of an optical system sensor from laser radiation incident on that system in its wavelength region of transparency.

## C. Disk Systems

As discussed below, the inherent tendency of rotating disk substrate carriers to effect different deposition rates in the radial direction is compensated by rotating the substrates on the disk itself (FIGS. 7 to 9), by moving the deposition device radially along the disk at a velocity proportional to the radial position (FIG. 9), by the use of a target/device width which increases with increasing radial distance, and/or by masking the deposition device.

FIG. 7 depicts a system 160 in which a main substrate carrier disk 162 is mounted for rotation in the direction 164. Sputter cathode and reaction stations such as 26, 27 and 28 are positioned facing the disks, opposite one or both major surfaces thereof. To increase deposition uniformly, the substrates can be mounted on smaller disks 166. The smaller disks 166 can be mounted for independent rotation or can be part of a planetary gear train which rotates the disks at a rate which is a function of the rotational speed of the main disk 162.

Alternatively, the substrates can be mounted at fixed positions on disk 162. To enhance uniformity, the sputter cathodes/deposition devices can be formed in a pie-shaped configuration or other configuration in which the target/device width increases with increasing radial distance. Also, the cathode/device can be masked.

The disk system 160 can be operated in a continuous mode or in an indexed mode. For continuous operation, the disk 162 is continuously rotated past the deposition device(s) 26, 27 and reaction device(s) 28 and, preferably, the smaller disks 166 are rotated to enhance axial processing uniformity. Rotation varies the radial position of the disks and the substrates thereon relative to the radially-extending deposition and reaction devices 26, 27, 28. For indexed operation, the drum 162 is selectively moved between work stations and, during processing at the selected station(s), the smaller disks 166 are rotated.

In an alternative disk system 160A depicted in FIG. 20, the deposition devices such as 26, 27 and/or the reaction devices 28 are mounted on a slide arrangement 170 for controlled radial movement relative to the main disk 162, to enhance process uniformity. In a typical arrangement, the devices are slidably mounted on a guide shaft 172 and are translated radially by a motor-driven lead screw 174 or by a magnetic coupling drive arrangement under control of the system computer. This controlled movement tailors the residence time of the devices to their radial position. That is, the residence time of the devices 26, 27 and 28 is directly proportional to their radial distance from the center of the disk rotation. As indicated at 176, the substrates 15 can be mounted at fixed positions on the disk 162 or on the smaller disks 166.

FIG. 9 depicts another alternative embodiment 160B in which a centrifugal-force-hold, shaped disk 162A which is similar in configuration to the cone-shaped platens used to hold semiconductor wafers during fabrication operations such as ion implantation. The plane of the disk 162A is oriented at a small angle $\theta$, typically of a few degrees, relative to the normal 178 to the rotational axis 180. Consequently, upon rotation of disk 162A a component of centrifugal force holds the substrates 15 against the disk. This simple, centrifugal hold approach permits high rotation rates. This is advantageous because the amount of material deposited during each pass is fixed/limited. Throughput is thus limited by the rotational speed, and is increased by increasing the rotational speed.

The disk 162A, FIG. 9 , may be used in combination with the fixed or translatable deposition and reaction devices 26, 27, 28 depicted in FIGS.       and 8, respectively. Either or both fixed substrates 15 or substrate-holding smaller disks 166 may be mounted in/on the shaped disk 162A. carrier 162A.

In still another embodiment (not shown), the substrate may be stationary and the ion source reaction device may be an annular ion gun which is mounted concentrically about an S-gun sputtering target. The concentric devices are mounted on an xy stage or an Rθ stage which moves the deposition device and reaction device (such as an oxidizer) together to cover the substrate surface.

E. Alternative Deposition Sources and Associated System Arrangements

1. Sputter Gun

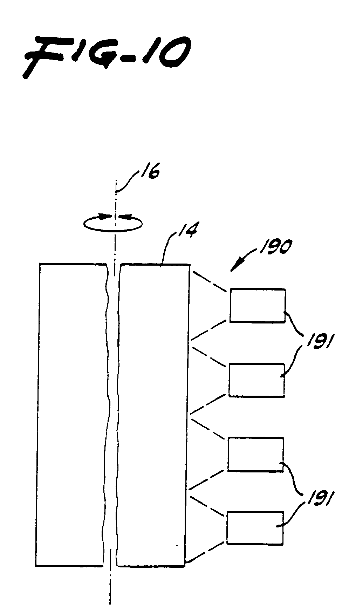

FIG. 10 schematically depicts another alternative deposition source arrangement, 190, which incorporates a so-called point source sputtering gun or S-gun 191 or, preferably, a plurality or multiplicity of such sputter guns 191. The sputter gun(s) 191 can be any of several commercially available sputter guns available from VacTec; Balzers; U.S., Inc. and other suppliers.

The devices 191 can be used with the substrate transport systems of FIGS. 7 to 9. The source 191 has a localized gas pressure that allows it to be used as a sputter source, but it coats somewhat similarly to a thermal source and can be located remote in the associated vacuum chamber in the manner of an evaporation source and operated as a remote sputtering device.

2. Thermal Evaporation Sources

a) Resistance-Heated Source

FIG. 11 schematically illustrates an alternative sputter source arrangement 200 which uses a standard thermal evaporation source 201 in conjunction with the horizontal-axis, single or double rotation drum-type substrate carrier 14. In operation, source material 202 in crucible 203 is evaporated by conventional means such as a resistance heater (not shown) so that the vaporized material 204 is deposited on substrates supported on the drum 14.

b. Electron Beam-Heated Source

FIG. 12 schematically illustrates an electron beam alternative 210 to the resistance heating arrangement 200, FIG. 32. Here, the system includes a source 212 of electrons, such as a standard, commercially available high voltage electron-beam gun. The electron gun 212 generates a beam 213 of electrons which are directed into the crucible 203, for example, using conventional control means such as a magnetic field (not shown), for evaporating the source material 202. A suitable electron-beam heating arrangement is described in US-A-4,777,908, to which reference should be made. Also a suitable electron beam heated, plasma plating arrangement is described in EP-A-0,384,617. This uses a capped/constant anode crucible, which provides improved electrical circuit continuity and improved plating performance.

C. Laser-Heated Source

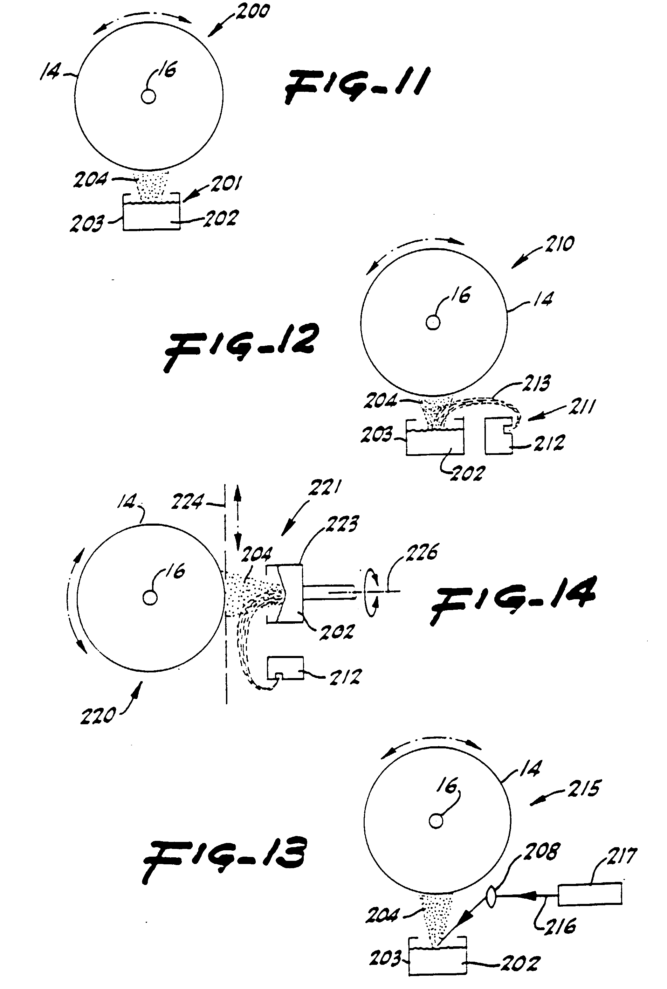

FIG. 13 schematically depicts still another alternative thermal evaporation arrangement 215. Here, the source material 202 is evaporated by a laser beam 216 and, typically, an optics control system 208 of lenses and/or other suitable control elements are used to direct the coherent beam 216 from laser 217 onto the source material 202.

d. Centrifugal Force System

FIG. 14 depicts a thermal evaporation arrangement 220 in which a centrifugal force side mount crucible 223 is mounted horizontally for rotation about axis 226 by motive means (not shown). A source such as the illustrated electron beam gun 212 or a laser is used to heat the source material 202, which is expelled laterally toward substrates mounted on horizontal drum 14 or vertically translatable carrier 224, etc. The centrifugal force generated by the rotation of the crucible 223 confines the molten pool of material within the crucible.

please note that the evaporation sources (resistive-heated, E-beams, and laser-heated sources) are more conveniently implemented in a horizontal axis drum configuration, but horizontal coating versions have been used. Also, like the S-gun 191, above, multiple sources, such as for example, a linear array of sources, are preferred for large coating systems.

e. Plasma Plating and Associated Deposition System

FIG. 15 depicts a modified, rotary version 230 of the plasma plating system disclosed in US-A-4,777,908. The latter system includes an electrically conductive crucible 231 which is positioned within the vacuum chamber 232 and is electrically insulated therefrom, but with a low resistance electrical connection therebetween. A high voltage electron beam source 233 is positioned within the vacuum chamber in the vicinity of the crucible 231 and includes a high voltage electron gun and a deflection magnet system (not shown) arranged for bending the electron beam 235 from the gun into the crucible for evaporating the source material therein. The magnet system also forms a magnetic field in the region above the crucible. A low voltage, high current plasma source including a separate plasma generating chamber 234 produces an intense first plasma in the plasma generating chamber using a selected activation gas species from a source 236 and this plasma is injected into the vacuum chamber 232. Also, the plasma source is electrically interconnected with the crucible to permit current flow between. Illustratively, the chamber incorporates one or more rotatable horizontal drum substrate carriers 14-14, thereby combining the high rate plasma plating capability of the incorporated Temple et al system with the uniformity and other advantages provided by rotary substrate transport. In addition, the incorporated plasma plating approach is adaptable to the in-line, disk and other transport systems which are described herein.

Using the above-described arrangement, the plasma source fills the vacuum chamber with a generally distributed plasma 237 which co-acts with the magnetic field above the crucible 231 and the evaporant material leaving the crucible 231 to form an intense second plasma 238 in the region above the crucible, thereby activating the evaporant material passing through the region for uniform deposition on the substrates mounted on the single axis or double axis rotary transport system. Thus, using the described rotary transport plasma plating scheme, thin films of various metals, refractory metals, metal oxides, etc., can be vacuum deposited uniformly and at high rate on the substrates.

### F. Alternative Reaction Sources and Associated System Arrangements

#### 1. Altered Inverse Linear Magnetron Ion Guns

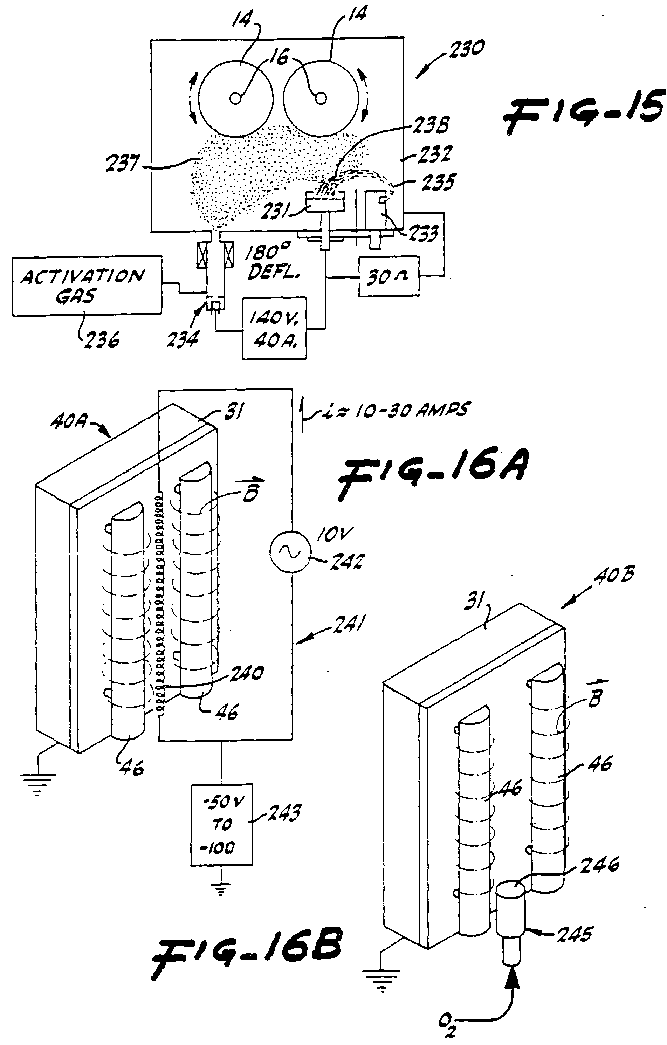

Understanding the problems solved by, and the advantages of, the altered inverse linear magnetron ion guns 40A and 40B depicted in FIGS. 16A and 16B may be aided by a review of the key aspects of the coating system depicted in FIG. 1 and of the above-discussed application of inverse linear magnetron ion gun 40 thereto.

The FIG. 1 vacuum coating chamber is separated into two regions, a metal sputtering zone characterized by a high partial pressure of argon as well as a high metal sputtering rate, and an independent reaction zone containing a high partial pressure of reactive gas along with an ionizing device to enhance reactivity. The substrates are alternated between the two zones on a rotating drum spinning with sufficient velocity to deposit only a few monolayers of metallic material during each pass. Using this technique, optical thin films can be deposited at high rates and with none of the target reaction instabilities associated with conventional reactive sputtering as this technology is known to us.

The above-described approach uses two types of ion guns which generate sufficient plasma density (2-10 amps output current) to fully react the metal films: a standard magnetron target 30 (FIGS. 3 and 4) sputtering in a low rate poisoned mode and a high current low energy, inverse linear magnetron ion gun 40 (FIGS. 5 and 6). Of the two reaction schemes, the inverse linear magnetron ion gun 40 is preferred because it provides kinetic energy to the ions which allows the drum rotational speed to be slowed and/or the metal sputtering rate to be increased. It has been known that ions with kinetic energies in the 100 eV range can penetrate and react thin metallic films to depths up to three monolayers, and the linear magnetron source 40 provides energy sufficient to this purpose. In contrast, reactive gas ions without this kinetic energy can react only one or two monolayers.

Despite these advantages of the ion gun 40, like everything in an imperfect world, both of the above-described two ion guns have areas where improvement is possible. In the case of the standard magnetron ion gun 30 (FIGS. 3 and 4), the magnetron operates in a relatively low rate poisoned mode which has some potential for arcing at high current densities and contaminating the deposited growing film. Moreover, the poisoned magnetron ionizes a relatively few percent of the reactive gas and provides no means to generate atomic reactive species or reactive products such as monatomic oxygen or ozone, nor does this device impart any kinetic energy to the ions.

As described above, the inverse linear magnetron ion gun 40 (FIGS. 5 and 6) depends on an auxiliary plasma created by the deposition device, i.e., on an existing plasma, to provide electrons for initial ignition and stable operation. As a consequence, operating characteristics of the ion gun such as anode voltage are a function of the existing plasma densities. If the auxiliary plasma is extinguished, the ion gun voltage can rise by a factor of as much as three to five. Also, the current output of the linear magnetron gun is limited due to arcing at higher current densities and due to electron deficiencies in the plasma. Such arcing could introduce contaminants, pinholes and absorption in the growing optical thin film. Moreover, the anodes in the inverse linear magnetron ion gun are exposed to the plasma and can become coated by scattered sputtered material. The anodes become hot due to electron heating; re-radiated energy can then provide a significant heat load on the chamber and substrates. Finally, the closed electrical circuit for the source may be somewhat hard to define because the magnetron target itself and the chamber walls can serve as cathodes to complete the circuit.

The altered inverse linear magnetron ion gun devices 40A, FIG. 16A, and 40B, FIG. 16B, are designed to eliminate the above difficulties by generating and maintaining their own independent, dedicated, high power stable auxiliary plasma. Key requirements for achieving these design goals are the ability to (1) generate a plasma local to the ion gun and (2) provide an electric current into the plasma equal to the ion gun current. Thermionic electron emission devices, cold cathode discharge devices and arc source devices such as those depicted in US-A-4,777,908, and EP-A-0384612 can be used. These devices are representative of a class of successful sources that emit electrodes and act as a cathode to the ion gun.

Referring to FIG. 16A the thermionic electron emission system 40A improves the basic inverse linear magnetron ion gun 40 depicted in FIGS. 5 and 6 by positioning a thermionic electron emission device such as a tungsten or tantalum filament 240 sufficiently close to (illustratively, between) the anode bars 46-46 for emitting electrons within the magnetic field $\bar{B}$. The filament 240 is connected to a power supply arrangement 241 comprising an AC signal source 242 of about 10 volts capable of supplying current of about 10 - 30 amps and a power supply 243 for biasing at about -50 to -100 volts, to heat the filaments sufficiently to provide thermionic emission of electrons. (The current and voltage values are illustrative only, and not limiting.) The power supply 54 (FIGS. 5 and 6) applies positive voltage to the anode bars 46-46 and generates the aforementioned racetrack configuration magnetic field, $\bar{B}$, which is transverse to the electric field E, i.e, $\vec{E} \times \vec{B}$. Due to the crossed electric and magnetic fields, electrons emitted from the filament 240 into the magnetic field are attracted to the anode bars 46-46, but are deflected by the magnetic field into spiral paths about the lines of flux, $\bar{B}$, such that the electron path length is increased, as are the number of ionizing collisions with the reactive gas molecules supplied by the manifold 57-57 (FIGS. 5 and 6). As a consequence. a dense plasma region is formed adjacent the anode bars 46-46 and a resulting high number density of reactive gas ions are accelerated by the potential between the anode bars and the substrate toward the substrate.

Referring now to FIG. 16B, the altered inverse linear magnetron ion gun system 40B incorporates an electron source 245 selected from a hollow cathode device and the arc source of the incorporated Temple et al patent and applications. The hollow cathode device contains material such as tantalum which emits electrons via secondary emission, and is biased to a sufficiently high voltage to provide secondary electrons and supply the desired concentration of electrons in the reactant gas stream emanating from the outlet 246. Illustratively, oxygen is the reactive gas. Exemplary hollow cathodes include the HC series available from Ion Tech, Inc. of Fort Collins, Colorado.

Please note, the operation of the devices 40A and 40B is not particularly sensitive to the placement of the filament 240 or the source 245. That is, operation is effective if the electron generating device is sufficiently close to the device to supply electrons to the fringes of the magnetic field and so that the electrons are attracted to the bars by the associated electric $\vec{E} \times \vec{B}$ field.

## 2. Point Source Ion Guns

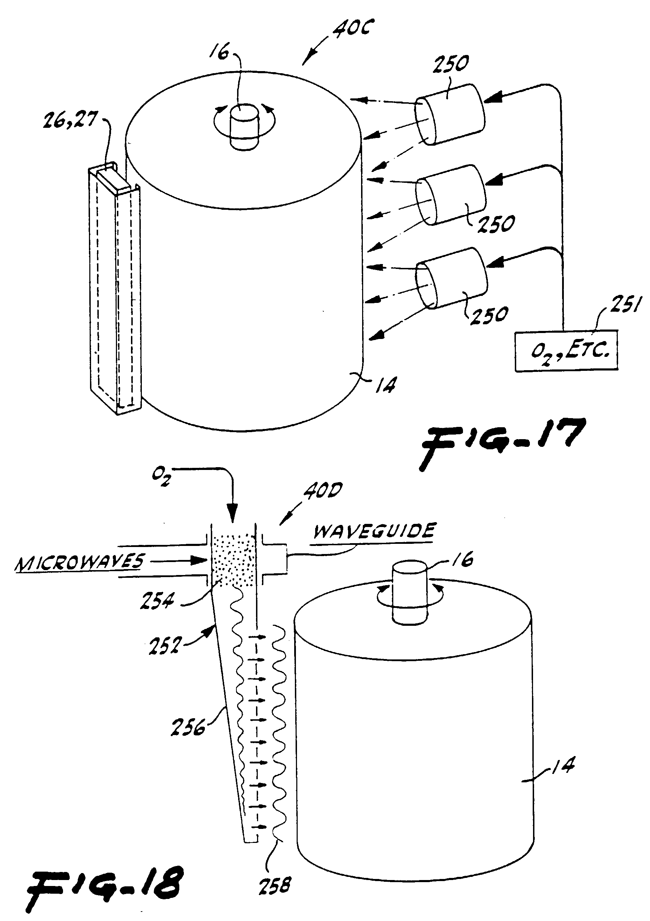

FIG. 17 depicts still another alternative ion gun system 40C, one employing a so-called point source ion gun 250 and a source 251 of reactive gas such as oxygen. Preferably, a plurality (or multiplicity) of such guns are aligned along the axis of the drum to provide the necessary coverage along that dimension. The gun(s) can be any of several commercially available ion gun sources which have the proper energy and current capacity. One example is the above-mentioned end-Hall Mark I ion source unit available from Commonwealth Scientific Corporation, Alexandria, Virginia, which has an output current capability of nearly 1-2 amps and supplies ion energies of 50 - 250 volts.

Unlike the cathode sputtering devices, the uniformity of operation and precise placement of the reaction source is not critical. The key is to define an array that would achieve a saturated reaction. That saturation limit can be achieved by various numbers and arrays of ion source devices.

## 3. Low Ion Energy Sources

Another approach is to use low ion energy, high power plasma sources to achieve the necessary reaction to form stoichiometric films of controlled density and low stress. Such plasmas react only fractional monolayers and, thus, must be used at relatively high substrate drum rotational speeds or relatively lower metal deposition rates. Microwave, RF, arc and magnetron, plasma-generating systems are applicable to this approach, and to produce cleaner, more stable plasmas. Many of these sources provide much higher ionization efficiencies than even the magnetron ion sources and, as a result, activation of the reactant gases is increased and the corresponding non-energetic reactive gas loads on the chamber and process are reduced.

Also, low energy ion sources may have advantages for the deposition of films such as indium tin oxide (ITO) and low temperature super conductors because they lessen the damage to the film crystal structure caused by impinging kinetic ions. Argon implantation also will be reduced.

## a. Microwave Sources

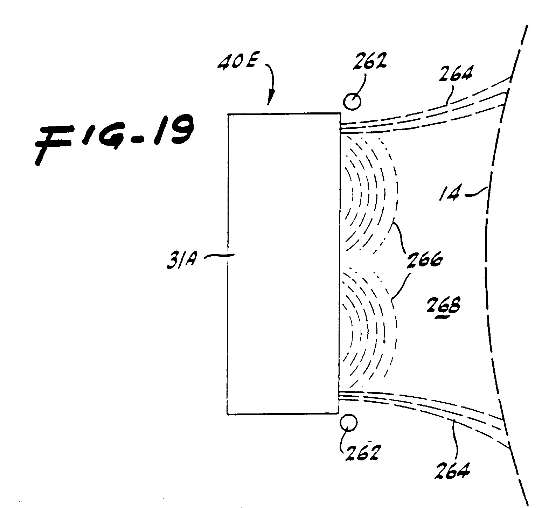

FIG. 18 depicts a microwave plasma source system 40D of the type alluded to above. In microwave device 252, microwave energy is applied to a reactive gas such as oxygen to produce a plasma 254 containing a high concentration of metal stable ions and free radicals as well as ions suitable for use in chemical vapor deposition, etching and reactive deposition. A manifold 256 is used to extend the microwave discharge axially along the drum 14, as indicated at 258, to provide the required coverage of the rotating drum. Such devices contain no sputtering elements or filaments and, thus, have long operating lives. Also, the microwave discharge can maintain high ionization efficiency at low pressures to reduce the reactive gas loads on the process.

Please note, a number of commercially-available microwave sources can provide from 1 to 1.5 kilowatts of controllable microwave power as a downstream microwave source. Examples include the downstream sources available from ASTEX, Applied Science and Technology, Inc., of Cambridge, Mass., including the model DPH 25 Downstream Plasma Head. Also, commercially available ECR (electron cyclotron resonance) sources, such as the ASTEX ECR Plasma Source, are applicable. The combination of such sources with an appropriate manifold such as 256 provides an effective and clean reaction scheme.

### b. Unbalanced Magnetron Source

FIG. 19 depicts another low temperature ion source system 40E, one employing an unbalanced magnetron. Here, a standard linear magnetron sputter source has been modified by the addition of auxiliary side magnets 262, which generate weak magnetic fields 264 between the magnetron target and substrate drum and perpendicular to both. This magnetic field is in addition to the conventional racetrack-shaped field 266. This modified linear magnetron sputter source 31A confines the plasma to a localized area 268 between the magnetic fields 264 and, thus, increases the plasma voltage relative to the chamber ground. As a consequence, the overall plasma density is increased and the rotating substrate is bombarded with low energy, ionized, reactive gas species for effecting the desired reaction with the previously deposited film.

### c. RF Source

US-A-4,361,114, to which reference should be made, discloses a plasma activation RF source (not shown) for use with a conventional evaporation source arrangement. The source comprises a tube of material such as silica which forms a cavity through which oxygen flows. A coil surrounding the tube is driven by RF energy of sufficient power to produce a sustained plasma. The plasma is allowed to enter the chamber through a manifold in such a manner as to produce relative plasma uniformity over the actual length of the associated drum 14.

### d. Electron Gun

The low voltage electron gun 234, (FIG. 18 in EP-A-0384616) can be biased to a separate anode in the chamber to flood the reaction zone with low temperature, is power density ions. Such a plasma arc electron source has been shown to operate at up to 100 amps output current; a large proportion of the oxygen entering the chamber is ionized.

### 5. Reactivity Enhancers

The reactivity of growing oxide films is increased by the application of enhancers such as ozone and nitrous oxide to the reaction zone via the gas inlet manifolds 57, FIGS. 5 and 6. Ozone generated by commercially-available generators can be liquified and stored and bled into the chamber through the oxygen gas manifold 57. Similarly, nitrous oxide, $N_2O$, can be bled into the gas in the manifold for the purpose of increasing the reactivity.

Also, ultraviolet eximer laser radiation increases the reactivity of silicon films when the photon energy is raised just above the oxygen dissociation energy. Similar effects are predicted for materials such as tantalum and titanium. Consequently, it is anticipated that the application of ultraviolet eximer laser energy to growing films of such materials, for example, through a quartz window in the chamber, alone or in combination with the use of reactive gas enhancers such as those described above and in further combination with any of the above-described reaction sources, will further enhance the reactivity provided by our system.

### G. Interchangeable Linear Magnetron Sputtering and Reaction Sources

Referring to FIGS. 4 and 5, the so-called "cat box" (comprising the baffle 32, FIG. 4, or at least the section thereof in front of the electrode assembly 31, plus the manifold 37) and the ion fixture, FIG. 6 (comprising the plate 43, anodes 46 and manifold 57) can be mounted for shuttling back and forth over in front of the electrode assembly 31. This permits selective use of the electrode for sputter deposition and reaction. For example, the cat box assembly and ion fixture assembly can be slidably mounted on rails extending generally parallel to the face of the electrode assemby 31 and on either side thereof, to permit selective positioning of the assemblies over and to the side of the cathode. With the cat box in place over the cathode, the device is used for sputtering, whereas positioning the ion fixture over the electrode assembly permits reactive operation of the device (e.g., oxidation of the sputter deposited film).

The arrangements of Figures 11 to 15 and 17 to 19 illustrate substrate carriers in the form of rotary drums which are not part of the present invention.

## Claims

1. A coating apparatus comprising, a vacuum chamber, carrier means (162) mounted within said chamber and adapted for mounting substrates thereon; coating means comprising at least a first device (26,27) in the form of a deposition device positioned adjacent the carrier means and adapted for depositing a selected material onto the substrates and at least a second device (28) in the form of an ion source device positioned adjacent the carrier means and adapted for providing a locally intensified plasma between the ion source and the carrier means for effecting a selected chemical reaction with the selected material, the deposition device and the ion source device being spatially separated such that each acts on a different portion of said carrier means, the carrier means and the coating means being adapted for relative movement along a selected path, and the coating means being positioned adjacent said path of movement, the combination of carrier configuration, deposition device configuration and said relative movement being selected to provide controlled thickness profiles for deposited material; characterised in that said path is circular and the carrier means is flat or the plane of the carrier means is orientated at a small angle relative to the normal (178) to the rotational axis (180) and is adapted for movement along said path generally parallel the coating means.

2. A coating apparatus as claimed in claim 1, characterised in that the carrier means further comprises means mounting the substrates thereto for movement transverse to the rotational path of movement.

3. A coating apparatus as claimed in claim 1, characterised in that the carrier means is adapted for mounting substrates thereon in an array oriented generally transverse to the axis of rotation of the carrier means and for rotating the substrates about said axis of rotation; and in that the coating means comprises at least one film deposition device positioned at a work station adjacent and facing the substrate array and adapted for depositing a selected material onto the substrates and at least one ion source device positioned adjacent and facing the substrate array and adapted for providing a plasma for effecting chemical reaction with the deposited material; and in that the devices are adapted for movement relative to the carrier means, transverse to the axis of rotation.

4. A coating apparatus as claimed in claim 3, characterised in that the devices are mounted for selected radial movement relative to the carrier means.

5. A coating apparatus as claimed in any of claims 1 to 4, characterised in that the deposition device is selected from a magnetron-enhanced device, one or an array of point source sputter guns, a stationary evaporation source, a centrifugal-force rotating evaporation source and a reactive ion plating source and the at least one ion source device is selected from a self-starting magnetron device, a point source device and a device adapted for generating a plasma of low energy ions.

6. A coating apparatus as claimed in any of claims 1 to 5, characterised in that the ion source device comprises electrode means adapted for receiving a selected voltage for generating a controlled electric field gradient between the ion source device and the carrier means; means for applying a magnetic field about the electrode means transverse to the electric field; manifold means for supplying gas locally to the electrode means; and means for supplying electrons locally to the electrode means and into the region of transverse electric and magnetic fields, for forming a plasma of said gas, whereby reactive gas ions are accelerated by said electrode potential along the electric field gradient toward the traversing means and substrates.

7. A coating apparatus as claimed in any of claims 1 to 6, characterised in that the ion source device is adapted to provide a locally intensified plasma in a long narrow reaction zone adjacent the carrier means.

8. A process for forming optical coatings on substrates comprising: mounting the substrate on carrier means within a vacuum chamber; providing coating means comprising at least a first device in the form of a deposition device positioned adjacent the carrier means and adapted for depositing a selected material onto the substrates and at least a second device in the form of an ion source device positioned adjacent the carrier means and adapted for providing a plasma for effecting a selected chemical reaction with the selected material; and operating the coating means for forming a selected optical coating on the substrates while moving at least one of the carrier means and the coating means relative to the other along a path selected to provide substantially equal deposition rates for similarly configured spaced substrates; characterised in that the carrier means is flat or the plane of the carrier means is orientated at a small angle relative to the normal to the rotational axis and adapted for mounting substrates thereon in a plane oriented generally perpendicular to the axis of rotation of the carrier means; providing at least one deposition device positioned at a work station adjacent and facing the substrate plane; providing at least one ion source device positioned adjacent and facing the substrate plane for providing a locally intense plasma adjacent the workpiece carrier; introducing working and reactive gases and rotating the carrier means to move the substrates past the first and second devices through said reaction zone associated with the second reaction device.

9. A process as claimed in claim 8, further comprising selectively operating the deposition and the reaction devices simultaneously or sequentially to form a composite coating comprising at least a plurality of layers, the composition of each said layer being selected from at least one of a first metal, a second metal, an oxide of the first metal, an oxide of the second metal, mixtures of the first and second metals and oxides of mixtures of the first and second metals.

10. A process as claimed in claim 8 or claim 9, further comprising providing at least a plurality of the deposition devices; sequentially operating selected ones of the deposition devices to sputter deposit layers of selected materials on the substrates and selectively operating the at least one reaction device in conjunction with supplying selected reactant gas thereto simultaneously with the operation of one or more of the depositon devices while continuously rotating the carrier means, for effecting the selected reaction with at least selected ones of the layers prior to sputter deposition of the next successive layer.

11. A process as claimed in any of claims 8 to 10, characterised in that the selected reaction involves selectively converting the deposited material to at least one of oxide, nitride, hydride, sulfide, fluoride, and carbide compounds and mixtures.

12. A process as claimed in any of claims 8 to 10 characterised in that the selected reaction selectively converts the deposited material to oxide.

13. A process as claimed in any of claims 9-11, characterised by the steps of continuously rotating the workpiece carrier and continuously operating a reaction device while alternately operating at least two of the deposition devices for depositing different materials alternately, thereby forming a multilayer coating comprising reacted layers of the alternating materials.

14. A process as claimed in any of claims 8 to 13, characterised in that the ion source devices provides a locally intense plasma in a long narrow reaction zone adjacent the workpiece carrier.

**Patentansprüche**

1. Beschichtungsvorrichtung mit einer Vakuumkammer, mit einer innerhalb der Kammer angeordneten Trägereinrichtung (162), auf der mehrere Substrate angebracht werden können, mit einer Beschichtungseinrichtung, die wenigstens eine erste Vorrichtung (26, 27) in Form einer Abscheidungsvorrichtung, die angrenzend an die Trägereinrichtung angeordnet und zur Abscheidung eines gewählten Materials auf die Substrate geeignet ist, und wenigstens eine zweite Vorrichtung (28) in Form einer Ionenquellenvorrichtung umfaßt, die angrenzend an die Trägereinrichtung angeordnet und zur Vorsehung eines örtlich intensivierten Plasmas zwischen der Ionenquelle und der Trägereinrichtung geeignet ist, um eine gewählte chemische Reaktion mit dem gewählten Material zu bewirken, wobei die Abscheidungsvorrichtung und die Ionenquellenvorrichtung räumlich getrennt sind, so daß sie jeweils auf einen unterschiedlichen Abschnitt der Trägereinrichtung wirken, die Trägereinrichtung und die Beschichtungseinrichtung für eine Relativbewegung entlang eines gewählten Weges geeignet sind, und die Beschichtungseinrichtung angrenzend an den Bewegungsweg angeordnet ist, wobei die Kombination der Ausgestaltung des Trägers, der Ausgestaltung der Abscheidungsvorrichtung und der Relativbewegung so gewählt ist, daß gesteuerte Dickenprofile des abgeschiedenen Materials vorgesehen werden können, dadurch gekennzeichnet, daß der Weg kreisförmig ist und die Trägereinrichtung eben ist oder die Ebene der Trägereinrichtung in einem geringen Winkel bezüglich der Normalen (178) der Drehachse (180) ausgerichtet ist und sich entlang des Weges insgesamt parallel zur Beschichtungseinrichtung bewegen kann.

2. Beschichtungsvorrichtung nach Anspruch 1, dadurch gekennzeichnet, daß die Trägereinrichtung außerdem eine Einrichtung umfaßt, die die Substrate für eine Bewegung quer zum Rotationsbewegungsweg an ihr anbringt.

3. Beschichtungsvorrichtung nach Anspruch 1, dadurch gekennzeichnet, daß an der Trägereinrichtung Substrate in einer Anordnung angebracht werden können, die insgesamt quer zur Rotationsachse der Trägereinrichtung verläuft, und die Trägereinrichtung zur Drehung der Substrate um die Drehachse geeignet ist, und daß die Beschichtungseinrichtung wenigstens eine Filmabscheidungsvorrichtung, die an einer Arbeitsstation angrenzend an die Substratanordnung und dieser zugewandt angeordnet ist und zur Abscheidung eines gewählten Materials auf die Substrate geeignet ist, und wenigstens eine Ionenquellenvorrichtung umfaßt, die angrenzend an die Substratanordnung angeordnet ist und dieser zugewandt ist und zur Schaffung eines Plasmas geeignet ist, um eine chemische Reaktion mit dem abgeschiedenen Material zu bewirken, und daß sich die Vorrichtungen relativ zu der Trägereinrichtung quer zur Drehachse bewegen können.

4. Beschichtungsvorrichtung nach Anspruch 3, dadurch gekennzeichnet, daß die Vorrichtungen für eine gewählte Radialbewegung relativ zu der Trägereinrichtung angebracht sind.

5. Beschichtungsvorrichtung nach einem der Ansprüche 1 bis 4, dadurch gekennzeichnet, daß die Abscheidungseinrichtung aus einer magnetronverstärkten Vorrichtung, einer Punktquellen-Zerstäuberkanone oder einer Anordnung von Punktquellen-Zerstäuberkanonen, einer stationären Bedampfungsquelle, einer Zentrifugalkraft-Rotationsbedampfungsquelle und einer reaktiven Ionenplattierungsquelle ausgewählt ist und die wenigstens eine Ionenquellenvorrichtung aus einer selbsterregten Magnetronvorrichtung, einer Punktquellenvorrichtung und einer Vorrichtung ausgewählt ist, die ein Plasma mit Ionen geringer Energie erzeugen kann.

6. Beschichtungsvorrichtung nach einem der Ansprüche 1 bis 5, dadurch gekennzeichnet, daß die Ionenquellenvorrichtung eine Elektrodeneinrichtung, die eine gewählte Spannung erhalten kann, um ein gesteuertes Gefälle des elektrischen Feldes zwischen der Ionenquellenvorrichtung und der Trägereinrichtung zu erzeugen, eine Einrichtung zur Aufbringung eines magnetischen Feldes um die Elektrodeneinrichtung quer zu dem elektrischen Feld, eine Verteilereinrichtung für eine örtliche Zufuhr von Gas zu der Elektrodeneinrichtung, und eine Einrichtung für eine örtliche Zufuhr von Elektronen zu der Elektroneneinrichtung und in den Bereich der quer verlaufenden elektrischen und magnetischen Felder umfaßt, um ein Plasma des Gases zu bilden, wodurch reaktive Gasionen durch das Eletrodenpotential entlang des Gefälles des elektrischen Feldes in Richtung der querenden Einrichtungen und Substrate zu beschleunigen.

7. Beschichtungsvorrichtung nach einem der Ansprüche 1 bis 6, dadurch gekennzeichnet, daß die Ionenquellenvorrichtung ein örtlich intensiviertes Plasma in einer langen schmalen Reaktionszone angrenzend an die Trägereinrichtung schaffen kann.

8. Verfahren zur Bildung optischer Beschichtungen auf Substraten, bei dem das Substrat auf einer Trägereinrichtung innerhalb einer Vakuumkammer angebracht wird, eine Beschichtungsvorrichtung vorgesehen wird, die wenigstens eine erste Vorrichtung in Form einer Abscheidungsvorrichtung, die angrenzend an die Trägereinrichtung angeordnet ist und zur Abscheidung eines gewählten Materials auf die Substrate geeignet ist, und wenigstens eine zweite Vorrichtung in der Form einer Ionenquellenvorrichtung umfaßt, die angrenzend an die Trägereinrichtung angeordnet ist und ein Plasma zur Bewirkung einer gewählten chemischen Reaktion mit dem gewählten Material schaffen kann, und bei dem die Beschichtungseinrichtung zur Bildung einer gewählten optischen Beschichtung auf den Substraten betrieben wird, während wenigstens die Trägereinrichtung und/oder die Beschichtungseinrichtung relativ zueinander entlang eines Weges bewegt werden, der zur Schaffung im wesentlichen gleicher Abscheidungsraten für ähnlich ausgebildete im Abstand angeordnete Substrate gewählt ist, dadurch gekennzeichnet, daß die Trägereinrichtung eben ist oder die Ebene der Trägereinrichtung in einem geringen Winkel bezüglich der Normalen der Drehachse ausgerichtet ist und Substrate auf ihr in einer Ebene angebracht werden können, die insgesamt senkrecht zur Drehachse der Trägereinrichtung verläuft, daß wenigstens eine Abscheidungsvorrichtung vorgesehen wird, die an einer Arbeitsstation angrenzend an die Substratebene und dieser zugewandt angeordnet ist, daß wenigstens eine Ionenquellenvorrichtung vorgesehen wird, die angrenzend an die Substratebene und dieser zugewandt angeordnet ist, um ein lokal intensives Plasma angrenzend an den Werkstückträger zu erzeugen, und daß ein Arbeitsgas und ein reaktives Gas eingeführt wird und die Trägereinrichtung gedreht wird, um die Substrate an der ersten und der zweiten Vorrichtung vorbei durch die Reaktionszone zu bewegen, die der zweiten Reaktionsvorrichtung zugeordnet ist.

9. Verfahren nach Anspruch 8, bei dem außerdem die Abscheidungsvorrichtung und die Reaktionsvorrichtung wahlweise gleichzeitig oder aufeinanderfolgend betrieben werden, um eine zusammengesetzte Beschichtung zu bilden, die wenigstens eine Vielzahl von Schichten umfaßt, wobei die Zusammensetzung jeder Schicht aus wenigstens einem ersten Metall, einem zweiten Metall, einem Oxid des ersten Metalls, einem Oxid des zweiten Metalls, Mischungen des ersten und zweiten Metalls und Oxiden von Mischungen des ersten und zweiten Metalls ausgewählt wird.

10. Verfahren nach Anspruch 8 oder Anspruch 9, bei dem außerdem wenigstens eine Vielzahl von Abscheidungsvorrichtungen vorgesehen werden, aufeinanderfolgend gewählte Abscheidungsvorrichtungen betrieben werden, um Abscheidungsschichten aus gewählten Materialien auf die Substrate zu sputtern und wahlweise die wenigstens eine Reaktionsvorrichtung in Verbindung mit einer Zufuhr eines ausgewählten Reaktionsgases zu ihr gleichzeitig mit dem Betrieb einer oder mehrerer der Abscheidungsvorrichtungen betrieben wird, während die Trägereinrichtung fortlaufend gedreht wird, um die gewählte Reaktion mit wenigstens gewählten Schichten vor der Sputterabscheidung der nächsten darauffolgenden Schicht zu bewirken.

11. Verfahren nach einem der Ansprüche 8 bis 10, dadurch gekennzeichnet, daß die gewählte Reaktion eine wahlweise Umwandlung des abgeschiedenen Materials in wenigstens eine Oxid-, Nitrid-, Hydrid-, Sulfid-, Fluorid- oder Carbidverbindung oder -mischung mit sich bringt.

12. Verfahren nach einem der Ansprüche 8 bis 10, dadurch gekennzeichnet, daß die gewählte Reakion das abgeschiedene Material wahlweise in Oxid umwandelt.

13. Verfahren nach einem der Ansprüche 9 bis 11, gekennzeichnet durch die Schritte, daß der Werkstückträger fortlaufend gedreht und eine Reaktionsvorrichtung fortlaufend betrieben wird, während abwechselnd wenigstens zwei der Abscheidungsvorrichtungen zur abwechselnden Abscheidung verschiedener Materialien betrieben werden, wodurch eine Mehrschichtbeschichtung gebildet wird, die Schichten der abwechselnden Materialien umfaßt, die eine Reaktion eingegangen sind.

14. Verfahren nach einem der Ansprüche 8 bis 13, dadurch gekennzeichnet, daß die Ionenquellenvorrichtungen ein lokal intensives Plasma in einer langen, schmalen Reaktionszone angrenzend an den Werkstückträger schaffen.

## Revendications

1. Appareil de revêtement comportant une chambre à vide, un moyen (162) de support monté dans ladite chambre et sur lequel des substrats sont destinés à être montés ; des moyens de revêtement comportant au moins un premier dispositif (26, 27) sous la forme d'un dispositif de déposition placé de façon à être adjacent au moyen de support et destiné à déposer une matière choisie sur les substrats, et au moins un second dispositif (28) sous la forme d'un dispositif à source d'ions, placé de façon à être adjacent au moyen de support et destiné à produire un plasma intensifié localement entre la source d'ions et le moyen de support afin d'effectuer une action chimique choisie avec la matière choisie, le dispositif de déposition et le dispositif à source d'ions étant séparés spatialement de manière que chacun d'eux agisse sur une partie différente dudit moyen de support, le moyen de support et les moyens de revêtement étant destinés à effectuer un mouvement relatif le long d'un trajet choisi, et les moyens de revêtement étant placés de façon à être adjacents audit trajet de mouvement, la combinaison d'une configuration du moyen de support, d'une configuration du dispositif de déposition et dudit mouvement relatif étant choisie pour établir des profils d'épaisseur commandée pour une matière déposée ; caractérisé en ce que ledit trajet est circulaire et le moyen de support est plat, ou bien le plan du moyen de support est orienté de façon à former un petit angle avec la normale (178) à l'axe de rotation (180), et est destiné à se déplacer le long dudit trajet à peu près parallèlement aux moyens de revêtement.

2. Appareil de revêtement selon la revendication 1, caractérisé en ce que le moyen de support comporte en outre des moyens de montage des substrats sur ce moyen de support pour effectuer un mouvement transversal au trajet du mouvement de rotation.

3. Appareil de revêtement selon la revendication 1, caractérisé en ce que le moyen de support est destiné au montage de substrats sur ce moyen suivant une rangée orientée à peu près transversalement à l'axe de rotation du moyen de support, et à faire tourner les substrats autour dudit axe de rotation ; et en ce que les moyens de revêtement comprennent au moins un dispositif de déposition de film placé dans un poste de travail adjacent et face à la rangée de substrats et destiné à déposer une matière choisie sur les substrats, et au moins un dispositif à source d'ions placé de façon à être adjacent et face à la rangée de substrats et destiné à produire un plasma pour effectuer une réaction chimique avec la matière déposée ; et en ce que les dispositifs sont destinés à se déplacer par rapport au moyen de support, transversalement à l'axe de rotation.

4. Appareil de revêtement selon la revendication 3, caractérisé en ce que les dispositifs sont montés de façon à effectuer un mouvement radial choisi par rapport au moyen de support.

5. Appareil de revêtement selon l'une quelconque des revendications 1 à 4, caractérisé en ce que le dispositif de déposition est choisi parmi un dispositif à amplification par magnétron, un pistolet de pulvérisation ou une rangée de pistolets de pulvérisation à source ponctuelle, une source immobile d'évaporation, une source d'évaporation tournante à force centrifuge et une source de placage ionique réactif, et le ou chaque dispositif à source d'ions est choisi parmi un dispositif à magnétron à auto-amorçage, un dispositif à source ponctuelle et un dispositif destiné à générer un plasma d'ions à faible énergie.

6. Appareil de revêtement selon l'une quelconque des revendications 1 à 5, caractérisé en ce que le dispositif à source d'ions comporte des moyens à électrodes destinés à recevoir une tension choisie pour générer un gradient de champ électrique commandé entre le dispositif à source d'ions et le moyen de support ; des moyens destinés à appliquer un champ magnétique autour des moyens à électrodes, transversalement au champ électrique ; des moyens distributeurs destinés à amener un gaz localement aux moyens à électrodes, et des moyens destinés à fournir localement des électrons aux moyens à électrodes et dans la zone des champs électriques et magnétiques transversaux, afin de former un plasma dudit gaz, grâce à quoi des ions de gaz réactif sont accélérés par ledit potentiel d'électrodes le long du gradient de champ électrique vers les moyens en mouvement et les substrats.

7. Appareil de revêtement selon l'une quelconque des revendications 1 à 6, caractérisé en ce que le dispositif à source d'ions est destiné à produire un plasma intensifié localement dans une zone de réaction longue et étroite, adjacente au moyen de support.

8. Procédé pour former des revêtements optiques sur des substrats, comprenant : le montage du substrat sur un moyen de support dans une chambre à vide ; l'utilisation de moyens de revêtement comportant au moins un premier dispositif sous la forme d'un dispositif de déposition placé de façon à être adjacent au moyen de support et destiné à déposer une matière choisie sur les substrats, et au moins un second dispositif sous la forme d'un dispositif à source d'ions placé de façon à être adjacent au moyen de support destiné à produire un plasma pour effectuer une réaction chimique choisie avec la matière choisie et la mise en oeuvre des moyens de revêtement pour former un revêtement optique choisi sur le substrat tout en déplaçant au moins l'un du moyen de support et des moyens de revêtement par rapport à l'autre le long d'un trajet choisi pour établir des vitesses de déposition sensiblement égales pour des substrats espacés, de configurations similaires ; caractérisé en ce que le moyen de support est plat ou bien le plan du moyen de support est orienté de façon à former un petit angle avec la normale à l'axe de rotation, et est destiné au montage de substrats sur ce moyen de support dans un plan orienté à peu près perpendiculairement à l'axe de rotation du moyen de support ; on utilise au moins un dispositif de déposition placé dans un poste de travail adjacent et face au plan du substrat ; on utilise au moins un dispositif à source d'ions placé de façon à être adjacent et face au plan du substrat pour produire un plasma localement intense adjacent au support de pièces ; on introduit des gaz de travail et de réaction et on fait tourner le moyen de support pour faire passer les substrats devant les premier et second dispositifs à travers ladite zone de réaction associée au second dispositif de réaction.

9. Procédé selon la revendication 8, comprenant en outre la mise en oeuvre sélective des dispositifs de déposition et de réaction, simultanément ou séquentiellement, pour former un revêtement composite comprenant au moins plusieurs couches, la composition de chacune desdites couches étant choisie parmi au moins l'un d'un premier métal, d'un second métal, d'un oxyde du premier métal, d'un oxyde du second métal, de mélanges des premier et second métaux d'oxydes de mélanges des premier et second métaux.

10. Procédé selon la revendication 8 ou 9, comprenant en outre l'utilisation d'au moins plusieurs dispositifs de déposition ; la mise en oeuvre séquentielle de certains, choisis, des dispositifs de déposition pour pulvériser des couches déposées de matières choisies sur les substrats et la mise en oeuvre sélective du ou de chaque dispositif de réaction conjointement avec l'alimentation de ce dernier en un gaz réactionnel choisi, simultanément à la mise en oeuvre d'un ou plusieurs des dispositifs de déposition tout en faisant tourner en continu le moyen de support, pour effectuer la réaction choisie avec au moins certaines, choisies, des couches avant la déposition par pulvérisation de la couche immédiatement suivante.

11. Procédé selon l'une quelconque des revendications 8 à 10, caractérisé en ce que la réaction choisie consiste à transformer sélectivement la matière déposée en au moins l'un de composés et de mélanges d'oxyde, de nitrure, d'hydrure, de sulfure, de fluorure et de carbure.

12. Procédé selon l'une quelconque des revendications 8 à 10, caractérisé en ce que la réaction choisie transforme sélectivement la matière déposée en un oxyde.

13. Procédé selon l'une quelconque des revendications 9-11, caractérisé par les étapes dans lesquelles on fait tourner en continu le support de pièce et on fait fonctionner en continu un dispositif de réaction tout en faisant fonctionner en alternance au moins deux des dispositifs de déposition pour déposer alternativement des matières différentes, de façon à former un revêtement multicouche comprenant des couches ayant réagi des matières alternées.

14. Procédé selon l'une quelconque des revendications 8 à 13, caractérisé en ce que les dispositifs à sources d'ions produisent un plasma localement intense dans une zone de réaction longue et étroite adjacente au support de pièces.

FIG-1

**FIG-2**

**FIG-3**

COOLING H₂O

POWER SUPPLY

GAS

GAS

GAS

**FIG-4**

FIG-5

FIG-6

FIG-7

FIG-8

FIG-9

## FIG-10

FIG-11

FIG-12

FIG-14

FIG-13

FIG-15

FIG-16A

$i \approx$ 10-30 AMPS

10V
242

FIG-16B

ACTIVATION GAS
236

180° DEFL.

140V. 40A.

-50V TO -100
243

$O_2$

FIG-17

FIG-18

FIG-19